Europäisches Patentamt

European Patent Office

Office européen des brevets

(19)

(11) Numéro de publication : **0 618 454 A1**

## DEMANDE DE BREVET EUROPEEN

(12)

(21) Numéro de dépôt : 94400431.6

(22) Date de dépôt : 01.03.94

(51) Int. Cl.⁵ : **G01R 31/28, G01R 29/08**

(30) Priorité : 02.03.93 FR 9302375

(43) Date de publication de la demande :
05.10.94 Bulletin 94/40

(84) Etats contractants désignés :
CH DE FR GB LI

(71) Demandeur : GERAC GROUPEMENT D'ETUDE
ET DE RECHERCHE APPLIQUEE A LA
COMPATIBILITE
2, Rue Jean Rodier
F-31400 Toulouse (FR)

(72) Inventeur : **Dauchy, Eric**
THOMSON-CSF,
SCPI,
B.P. 329
F-92402 Courbevoie Cédex (FR)
Inventeur : **Meisse, Pascal**
THOMSON-CSF,
SCPI,
B.P. 329
F-92402 Courbevoie Cédex (FR)

(74) Mandataire : **Benoit, Monique et al**
THOMSON-CSF
SCPI
B.P. 329
50, rue Jean-Pierre Timbaud
F-92402 Courbevoie Cédex (FR)

(54) **Simulateur de champs à prédominance électrique, et son application aux essais d'équipements.**

(57) La présente invention concerne un simulateur de champs à prédominance électrique de type sinusoïdal amorti, et l'application de ce simulateur aux essais d'équipements électriques ou électroniques.

Le principe de fonctionnement du simulateur selon l'invention repose sur l'injection galvanique ou par couplage magnétique d'un signal électrique impulsionnel généré par des moyens (1) sur une structure allongée et résonante (3) s'étendant parallèlement à une distance d d'un plan de masse conducteur (2) et sur une longueur totale L. A l'extrémité libre (30) de cette structure, est généré par résonance un champ électrique prédominant de type sinusoïdal amorti, dont les caractéristiques de fréquence, de niveau maximal et de coefficient d'amortissement dépendent principalement de la distance d, de la longueur L et du matériau utilisé pour la structure. L'équipement à essayer est alors relié galvaniquement au plus proche de l'extrémité libre (30) de la structure (3).

Le simulateur objet de l'invention est particulièrement intéressant dans son utilisation comme moyen d'essais sur des équipements destinés à être embarqués sur des structures conductrices de grandes dimensions soumises à des agressions impulsionnelles électromagnétiques.

FIG.1a

EP 0 618 454 A1

La présente invention concerne un simulateur de champs à prédominance électrique, et une application de ce simulateur aux essais d'équipements.

Le domaine d'application visé plus particulièrement par la présente invention concerne les essais d'évaluation de recette ou de qualification d'équipements électriques ou électroniques destinés à être placés sur des structures conductrices présentant une grande dimension, du type aéronefs, missiles, bateaux ou véhicules terrestres. De telles structures conductrices, lorsqu'elles sont exposées à une agression électromagnétique impulsionnelle, telle que la foudre, vont générer sur leur surface des distributions de courants et de charges. Il en résulte la création de champs magnétiques et électriques plus ou moins importants selon l'endroit de la structure où l'on se place. Par exemple, une structure de type avion, soumise à une agression électromagnétique impulsionnelle, va générer notamment des champs électriques prédominants en tête et en queue de l'avion, ainsi qu'à l'extrémité des ailes, alors que le milieu de la carlingue va être le siège de champs magnétiques prédominants.

Ainsi, les équipements électroniques portés par les structures sont susceptibles d'être soumis à des champs électriques ou magnétiques intenses qui risquent de perturber leur fonctionnement ou de les endommager.

On comprend par conséquent aisément la nécessité de pouvoir recréer le plus fidèlement possible les champs prédominants générés par les structures porteuses dans un certain environnement électromagnétique, de façon à pouvoir étudier le comportement des équipements.

Nous nous intéresserons par la suite uniquement aux champs à prédominance électriques. Les simulations notamment mathématiques ont déjà permis de connaître les caractéristiques de ces champs électriques: il s'agit de champs sinusoïdaux amortis dont la pseudo-fréquence et le coefficient d'amortissement dépendent complètement de la structure porteuse qui génère les champs. Le niveau crête du champ électrique dépend quant à lui principalement de l'agression impulsionnelle extérieure à la structure.

Pour générer de tels champs, il a déjà été proposé un simulateur dont on trouvera une description complète dans les Annales de Télécommunications, 47, n° 1-2, 1992, pages 73 à 84: "Nouvelle classe de simulateurs permettant la caractérisation de dispositifs embarqués sur des structures de grandes dimensions". Un tel simulateur est constitué d'une ligne d'excitation comprenant deux nappes filaires verticales en vis-à-vis, alimentées par un générateur haute tension, et délivrant la forme et le niveau de l'agression incidente, ainsi qu'une structure métallique représentative de la structure porteuse, que l'on introduit, du moins en partie, à l'intérieur du volume défini par les deux nappes verticales, grâce à deux ouvertures pratiquées dans ces nappes. La structure métallique, qui se présente sensiblement sous la forme d'un parallélépipède allongé, est ainsi couplée à l'onde TEM créée par la ligne d'excitation, et génère des champs prédominants.

Le simulateur précédent permet de générer de façon satisfaisante des champs proches de ceux qui existent dans la réalité. Il présente cependant un certain nombre d'inconvénients:

La structure métallique utilisée, bien que considérablement simplifiée par rapport à la structure porteuse réelle qu'elle est censée représentée, doit cependant posséder une dimension égale à celle de la structure réelle. La ligne d'excitation doit alors présenter un volume suffisant pour accueillir cette structure métallique. L'encombrement du simulateur devient donc important lorsqu'il s'agit d'essayer des équipements embarqués. Cela entraîne nécessairement une mise en oeuvre lourde, longue. De plus, le simulateur est difficilement transportable.

En outre, un tel simulateur ne permet pas de faire varier simplement et rapidement les caractéristiques des champs électriques que l'on simule, notamment au niveau de la fréquence et du coefficient d'amortissement, puisqu'il est alors nécessaire de changer de structure métallique.

Par ailleurs, pour générer les agressions électromagnétiques impulsionnelles qui reflètent la réalité et obtenir des niveaux de champs électriques de l'ordre de 500 kV/m, le générateur utilisé doit fournir une haute tension, typiquement supérieure ou égale à 1 MV, ce qui impose d'utiliser des composants électriques spéciaux ainsi que des étages multiplicateurs de tension représentant un investissement lourd. En cas d'essais d'évaluation de recette d'un équipement, un tel générateur ne permet pas, du fait des hautes tensions mises en jeu, une incrémentation fine de son niveau de sortie.

La présente invention a pour objectif de pallier les inconvénients précités en proposant un simulateur répondant beaucoup mieux, de par sa souplesse d'utilisation, aux besoins rencontrés notamment lors d'essais d'évaluation de recette et/ou de qualification d'équipements électriques ou électroniques destinés à être embarqués sur des structures conductrices de grande dimension, à savoir:

- un encombrement faible, même pour simuler des champs électriques prédominants engendrés par de grandes ou très grandes structures;
- une facilité et rapidité d'adaptation en vue de faire varier un ou plusieurs paramètres caractéristiques des champs électriques simulés.

L'objectif précédent est atteint grâce à la présente invention, laquelle a plus précisément pour objet un simulateur de champs électriques prédominants de type sinusoïdal amorti dont les caractéristiques de fréquence, d'amplitude maximale et de coefficient d'amortissement sont prédéterminables, caractérisé en ce qu'il comporte :

- des moyens générant un signal électrique impulsionnel;
- un plan de masse conducteur; et
- une structure allongée résonante en matériau conducteur, qui s'étend sensiblement parallèlement à une distance d du plan de masse, sur une longueur total L,

lesdits moyens injectant le signal électrique impulsionnel entre la structure et le plan de masse par l'intermédiaire de moyens d'injection, le matériau conducteur étant choisi et la distance d et la longueur L étant ajustées de manière à générer par résonance, à une extrémité libre de la structure, un champ électrique prédominant ayant lesdites caractéristiques.

La présente invention a également pour objet une application du simulateur de champs électriques prédominants défini dans les revendications 1 à 10 aux essais d'équipement électrique ou électronique, caractérisée en ce que l'équipement est relié électriquement à proximité de l'extrémité libre de la structure allongée.

Selon deux variantes de fonctionnement, l'injection du signal sur la structure résonante s'effectue galvaniquement ou par couplage magnétique.

L'invention et les avantages qu'elle procure seront mieux compris au vu de la description suivante, faite en référence aux figures annexées:

- La figure 1a illustre une réalisation possible du simulateur selon l'invention, pour laquelle l'injection est galvanique et son application à l'essai d'un équipement;
- La figure 1b illustre une seconde variante du simulateur selon l'invention, pour laquelle l'injection est effectuée par couplage magnétique;
- La figure 2 représente le schéma électrique équivalent du simulateur de la figure 1a, pour lequel le générateur d'impulsion est un générateur double exponentielle;
- Les figures 3a et 3b sont des exemples de mesures de champs électrique et magnétique générés par le simulateur selon l'invention.

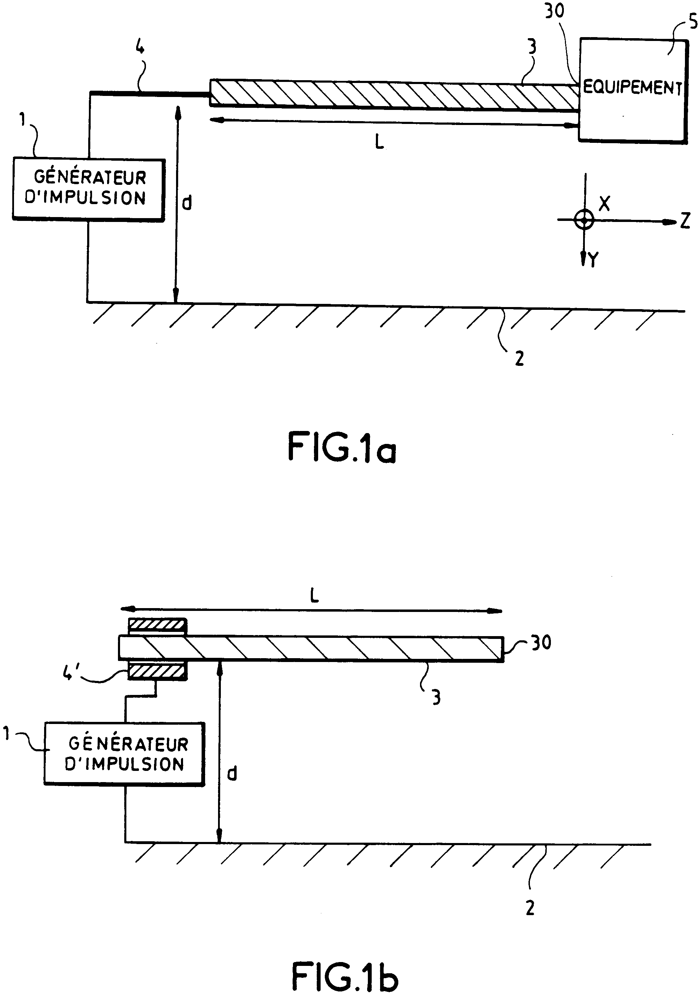

Le simulateur objet de l'invention, et tel qu'illustré à la figure 1a dans un mode de réalisation possible, est constitué essentiellement de moyens 1 qui génèrent un signal électrique impulsionnel, d'un plan de masse conducteur 2, et d'une structure allongée résonante en matériau conducteur. Le fonctionnement d'un tel simulateur selon l'invention est le suivant:

Le signal électrique impulsionnel délivré par les moyens 1 et représentatif d'une agression, est injecté galvaniquement sur la structure résonante 3, par exemple par l'intermédiaire d'un conducteur filaire 4. La structure 3 est placée à une distance d du plan de masse 2 et s'étend sensiblement parallèlement au plan de masse sur une longueur L. La distance d est choisie notamment pour éviter que le plan de masse ne perturbe la résonance de la structure. Lorsque la structure résonante 3 reçoit l'agression, un régime d'ondes oscillatoires amorties, dû à la résonance de la structure, va se créer. Le champ électrique, mesuré à l'extrémité libre 30 de la structure est de forme sinusoïdale amortie. La structure 3 étant en court-circuit du côté du générateur 1, et en circuit ouvert à son extrémité libre 30, la résonance s'effectue en $\lambda/4$ si $\lambda$ est la longueur d'onde. La fréquence f du champ électrique généré au niveau de l'extrémité libre de la structure résonante est ainsi donnée par la relation simplifiée :

$$f = \frac{c}{4(L + d)} \quad (1)$$

où c représente la vitesse de la lumière.

L'équipement 5 que l'on veut essayer doit être relié galvaniquement à la structure 3, et être situé au plus proche de l'extrémité libre 30.

Dans l'exemple de réalisation illustré à la figure 1a, la structure 3 présente une rigidité mécanique suffisante pour supporter directement l'équipement à son extrémité libre. On peut utiliser par exemple un tube en acier pour réaliser la structure résonante 3.

La figure 1b illustre une seconde variante de réalisation du simulateur selon l'invention, pour laquelle l'injection du signal électrique impulsionnel généré par les moyens 1 dans la structure résonante 3 se fait non plus galvaniquement, mais par couplage magnétique. On retrouve donc, sur la figure 1b, les mêmes éléments que sur la figure 1a, à l'exception du conducteur filaire 4. Dans cette variante, les moyens d'injection sont réalisés par un tore d'injection 4' dont l'axe est confondu avec l'axe longitudinal de la structure 3, et entourant la structure résonante 3. Le tore 4' est dimensionné pour effectuer l'injection du signal électrique impulsionnel par couplage magnétique.

Les moyens 1 générant l'impulsion électrique dépendent de l'agression à simuler. Dans le cas de la foudre, l'agression se présente sous la forme d'une impulsion double exponentielle.

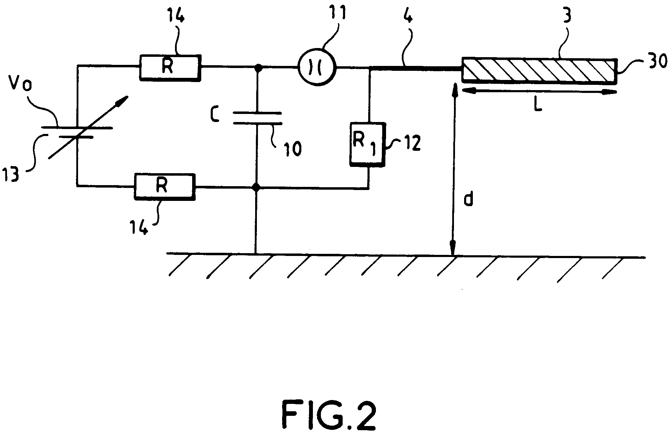

La figure 2 illustre le schéma électrique équivalent du simulateur de la figure 1a pour lequel les moyens 1 sont constitués d'un générateur double exponentielle:

Ce dernier est constitué d'une part, d'un circuit rebouclé comportant en série un condensateur 10, un éclateur 11 de tension d'amorçage donnée, et une résistance de charge 12 de valeur $R_1$, et d'autre part une alimentation 13 en tension continue $V_o$. Le fonctionnement d'un tel générateur est le suivant: La tension continue $V_o$ vient charger le condensateur 10 jusqu'à ce que la tension d'amorçage de l'éclateur 11 soit atteinte. Le condensateur 10 va alors se décharger dans la résistance de charge $R_1$ et dans la structure résonante. Des résistances 14 de forte valeur situées entre l'alimentation 13 et le condensateur 10 permettent de déconnecter électriquement l'alimentation au moment de la décharge du condensateur.

Les valeurs des différents composants sont déterminées en fonction du niveau et de la forme de l'agression que l'on cherche à obtenir.

Une alimentation $V_o$ de l'ordre de 100 kV permet d'obtenir, avec ce simulateur, des niveaux de champs électriques de l'ordre de 500 kV/m.

Notons que le générateur double exponentielle peut également injecter l'impulsion par couplage magnétique, comme décrit en référence à la figure 1b.

Le simulateur proposé par l'invention présente l'avantage d'être variable par nature, en ce sens qu'il permet de faire varier facilement et rapidement les différentes caractéristiques des champs électriques que l'on désire simuler:

En effet, il suffit de changer la longueur L de la structure résonante pour changer la fréquence du champ. En utilisant la relation (1) donnée précédemment, et pour une distance d fixée arbitrairement à 1 mètre, il est facile de démontrer qu'une longueur L comprise entre 24 mètres et 1,5 mètre permet de balayer la bande de fréquence [3 MHz; 30 MHz].

La longueur L de la structure et le matériau conducteur utilisé définissent quant à eux le coefficient d'amortissement du champ électrique. En outre, la forme de l'agression est fonction du générateur utilisé et peut par conséquent être facilement modifiée.

Enfin, dans le cas de l'utilisation d'un générateur double exponentielle tel que décrit par exemple en référence à la figure 2, le niveau du champ électrique peut être finement modifié en utilisant un éclateur à tension d'amorçage variable, ou alors, si l'éclateur est remplacé par un interrupteur, en utilisant une alimentation de tension $V_o$ variable.

Un deuxième avantage non négligeable du simulateur réside dans son faible encombrement par rapport aux simulateurs connus. Le simulateur objet de l'invention permet un gain minimal de 50% en longueur et de 90% en volume par rapport aux simulateurs connus.

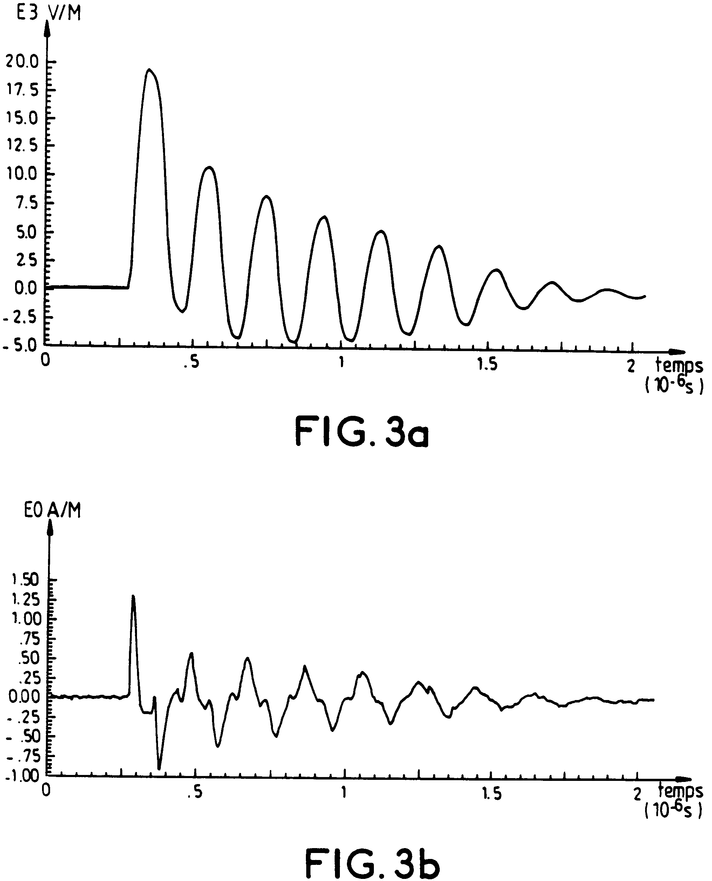

Les figures 3a et 3b représentent à titre d'exemples la mesure en fonction du temps d'un champ électrique et celle d'un champ magnétique générés par le simulateur de la figure 2 pour une tension $V_o$ de 3,9 KV, et une injection de l'agression sur un tube de 11 mètres situé à 1 mètre au-dessus du plan de masse, les champs ayant été relevés selon l'axe X de la figure 1.

La comparaison des courbes permet de conclure qu'il y a effectivement une forte prédominance de champ électrique par rapport au champ magnétique. En effet, l'amplitude maximale relevée est d'environ 20 kV/m pour le champ électrique, contre environ 1,3 A/m pour le champ magnétique, ce qui conduit à un rapport de l'impédance équivalente E/H de l'ordre de 15 kΩ.

D'autres mesures effectuées par la Demanderesse ont permis de montrer que les champs électriques prédominants obtenus par le simulateur selon l'invention étaient en outre homogènes dans l'espace. Un équipement à essayer peut donc a priori être orienté d'une façon quelconque.

Il est important de noter que le simulateur objet de l'invention peut présenter, sans sortir du cadre de l'invention, d'autres variantes de réalisations:

Ainsi, au niveau de la structure résonante utilisée, nous avons précédemment indiqué l'utilisation préférentielle d'un tube suffisamment rigide, par exemple en acier, qui présente l'intérêt de pouvoir supporter directement l'équipement à essayer à son extrémité libre. D'autres structures telles qu'un cylindre constitué de fils s'étendant sur toute la longueur, ou même un fil seul, peuvent également être utilisées. L'équipement devra dans ce cas être supporté par d'autres moyens, comme des cales ou des supports adaptés et isolants.

D'autre part, l'injection du signal électrique impulsionnel peut être effectuée en n'importe quel endroit de la structure résonante, notamment en son milieu.

Enfin, bien que ce simulateur ait été développé principalement pour servir de moyens d'essais sur des équipements embarqués sur des structures conductrices de grande dimension soumises, à une agression impulsionnelle électromagnétique, il peut être également utilisé dans toute application nécessitant la création d'un champ électrique prédominant de type sinusoïdal amorti.

**Revendications**

1. Simulateur de champs électriques prédominants de type sinusoïdal amorti dont les caractéristiques de fréquence, d'amplitude maximale et de coefficient d'amortissement sont prédéterminables, caractérisé en ce qu'il comporte :
   - des moyens (1) générant un signal électrique impulsionnel ;
   - un plan de masse conducteur (2); et
   - une structure allongée résonante (3) en matériau conducteur, qui s'étend sensiblement parallèlement à une distance d du plan de masse (2), sur une longueur total L,
   lesdits moyens (1) injectant le signal électrique impulsionnel entre la structure (3) et le plan de masse (2) par l'intermédiaire de moyens d'injection (4; 4'), le matériau conducteur étant choisi et la distance d et la longueur L étant ajustées de manière à générer par résonance, à une extrémité libre de la structure, un champ électrique prédominant ayant lesdites caractéristiques.

2. Simulateur de champs électriques prédominants selon la revendication 1, caractérisé en ce que le signal électrique impulsionnel est injecté à une extrémité de la structure (3).

3. Simulateur de champs électriques prédominants selon la revendication 1, caractérisé en ce que le signal électrique impulsionnel est injecté au milieu de la structure (3).

4. Simulateur de champs électriques prédominants selon l'une quelconque des revendications précédentes, caractérisé en ce que lesdits moyens (1) sont constitués d'un générateur double exponentielle.

5. Simulateur de champs électriques prédominants selon la revendication 4, caractérisé en ce que le générateur double exponentielle comporte un circuit rebouclé constitué d'un condensateur (10) relié au plan de masse (2), d'un éclateur (11) de tension d'amorçage donnée et d'une résistance de charge (14) reliée à un extrémité à l'éclateur (1) et à l'autre extrémité au condensateur et au plan de masse (2), et une alimentation en tension continue (13) qui vient charger le condensateur (10) jusqu'à ce que la tension d'amorçage soit atteinte.

6. Simulateur de champs électriques prédominants selon l'une quelconque des revendications précédentes, caractérisé en ce que ladite structure (3) est un tube.

7. Simulateur de champs électriques prédominants selon l'une quelconque des revendications 1 à 5, caractérisé en ce que ladite structure (3) est un cylindre constitué de fils s'étendant parallèlement sur la longueur L.

8. Simulateur de champs électriques prédominants selon l'une quelconque des revendications 1 à 5, caractérisé en ce que ladite structure (3) est un fil.

9. Simulateur de champs électriques prédominants selon l'une quelconque des revendications précédentes, caractérisé en ce que lesdits moyens d'injection sont constitués d'un conducteur filaire (4) réalisant une injection galvanique du signal électrique impulsionnel dans la structure résonante (3).

10. Simulateur de champs électriques prédominants selon l'une quelconque des revendications 1 à 8, caractérisé en ce que lesdits moyens d'injection sont constitués d'un tore (4') entourant la structure et réalisant une injection du signal électrique impulsionnel dans la structure résonante (3) par couplage magnétique.

11. Application du simulateur de champs électriques prédominants défini dans les revendications 1 à 10 aux essais d'équipement électrique ou électronique, caractérisée en ce que l'équipement (5) est relié électriquement à proximité de l'extrémité libre de la structure allongée (3).

12. Application du simulateur de champs électriques prédominants selon la revendication 11, caractérisée en ce que la structure (3) est suffisamment rigide et supporte directement l'équipement (5) à essayer à son extrémité libre.

FIG.1a

FIG.1b

6

# FIG.2

FIG. 3a

FIG. 3b

8

**Office européen des brevets**

# RAPPORT DE RECHERCHE EUROPEENNE

Numero de la demande

EP 94 40 0431

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | DE-C-142 793 (KALISHER)<br>--- | 1,3,7,11 | G01R31/28<br>G01R29/08 |
| Y | FR-A-2 662 260 (THOMSON)<br>*résumé*<br>--- | 1,3,7,11 | |
| A | GB-A-176 892 (ROUND)<br>--- | | |
| A | EP-A-0 526 643 (MITSUBISHI)<br>--- | | |
| A | FR-A-650 588 (LE MATERIEL TELEPHONIQUE)<br>----- | | |

| | DOMAINES TECHNIQUES RECHERCHES (Int.Cl.5) |
|---|---|
| | G01R<br>H01Q |

Le présent rapport a été établi pour toutes les revendications

| Lieu de la recherche | Date d'achèvement de la recherche | Examinateur |
|---|---|---|
| LA HAYE | 11 Avril 1994 | Hoornaert, W |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

....................................................................
& : membre de la même famille, document correspondant

EPO FORM 1503 03.82 (P04C02)

9